Europäisches Patentamt

European Patent Office

Office européen des brevets

(11) Publication number: **0 156 648 B1**

## EUROPEAN PATENT SPECIFICATION

(45) Date of publication of patent specification: **30.09.92**

(51) Int. Cl.⁵: **G06F 15/336, H03H 17/06, G06F 7/544, H03H 17/02**

(21) Application number: **85302161.6**

(22) Date of filing: **28.03.85**

(54) Convolution arithmetic circuit for digital signal processing.

(30) Priority: **29.03.84 JP 59450/84**
**29.03.84 JP 59451/84**
**29.03.84 JP 59452/84**

(43) Date of publication of application:
**02.10.85 Bulletin 85/40**

(45) Publication of the grant of the patent:
**30.09.92 Bulletin 92/40**

(84) Designated Contracting States:
**DE FR GB NL**

(56) References cited:
**DE-A- 3 111 889**
**FR-A- 2 417 806**

**ELEKTRONIK, vol. 29, no. 20, 2nd October 1980, pages 61-66, Munich, DE; L. KLAAS: "Digitales Transversalfilter als universeller Signalprozessor"**

**ELEKTRONIK, vol. 32, no. 3, February 1983, pages 85-88, Munich, DE; H.-J. KOLB: "Digitales FIR-Filter für die Messwertverarbeitung"**

(73) Proprietor: **KABUSHIKI KAISHA TOSHIBA**
**72, Horikawa-cho Saiwai-ku**
**Kawasaki-shi Kanagawa-ken 210(JP)**

(72) Inventor: **Konishi, Kazuo c/o Patent Division**
**Toshiba Corporation Principal Office**
**1-1, Shibaura 1-chome Minato-ku Tokyo(JP)**
Inventor: **Nishikawa, Meisei c/o Patent Division**
**Toshiba Corporation Principal Office**
**1-1, Shibaura 1-chome Minato-ku Tokyo(JP)**

(74) Representative: **Newstead, Michael John et al**
**Haseltine Lake & Co. 28 Southampton Buildings Chancery Lane**
**London, WC2A 1AT(GB)**

**Description**

BACKGROUND OF THE INVENTION

1. Field of the Invention

This invention relates to a convolution arithmetic circuit for a digital signal processing system such as a digital filter.

2. Description of the Prior Art

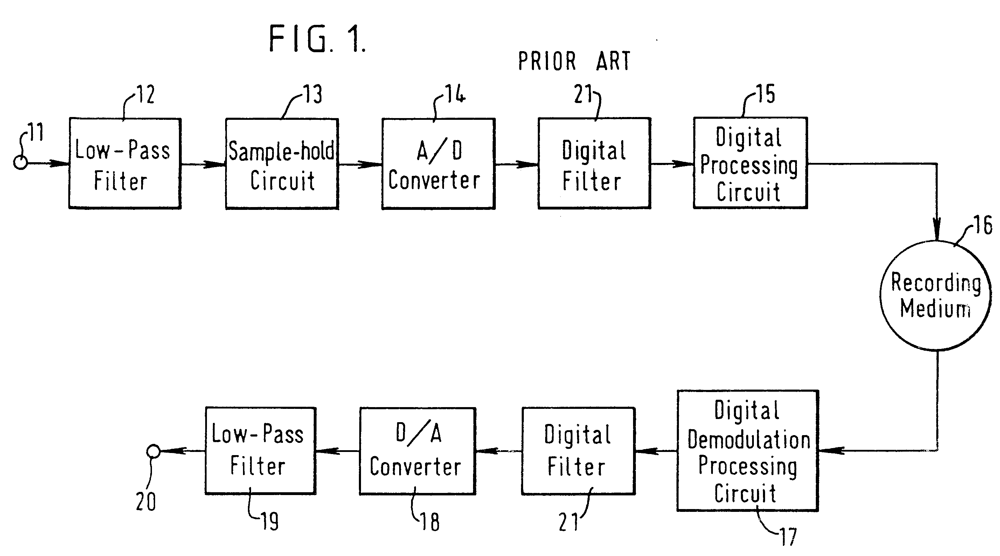

In recent years, widespread use has been made of digital recording and playback units such as PCM recorders or DAD (digital audio disc) players utilizing PCM (pulse code modulation) techniques to enable audio equipment to have as high fidelity as possible. Fig. 1 is a diagram of a digital recording and playback system according to prior art configurations. An analog signal, such as an audio signal, is input through terminal 11 and low-pass filter 12 removes unwanted high-frequency components from that signal. The output of filter 12 is supplied to sample-hold circuit 13, which samples the analog signal at a sampling frequency prescribed for the unit (e.g., 44.1 KHz in the case of a DAD player), for conversion into a digital signal by A/D (analog to digital) converter 14. Digital processing circuit 15 adds an error correction code and digital modulation to the digitized signal which is then recorded on a recording medium 16 such as a tape or a disc.

The original digital signal is recovered by digital demodulation processing circuit 17 which demodulates the playback signal from recording medium 16 and performs error correction for error resulting from, for example, defects in the recording medium 16. The digital signal is extracted as a continuous analog signal, i.e., the original audio signal, from the output terminal 20, after removing the high-frequency noise component by low-pass filter 19, and after step-wise conversion to an analog signal by D/A (digital to analog) converter 18.

When the analog signal is recovered by sampling using this digital recording and playback unit, high-frequency components biased about the sampling frequency are generated resulting in a high-frequency distribution near the upper limit of the original frequency band. Low-pass filter 19 must therefore have a steep filter characteristic to remove these components.

If a digital filter 21 is interposed after the A/D converter 14 or before the D/A converter 18 to remove the high-frequency components in the digital signal stage, the filter characteristic of the low-pass filter 19 need not be so steep.

Generally, there are two operations for providing digital data with a filtering characteristic. One is in the frequency domain and another is in the time domain. The former filtering operation is accomplished first by a fast Fourier translation (FFT) of an input digital data sequence x(t) in the time domain into digital data X(w) in the frequency domain. Then, by multiplying the digital data X(w) with a transmission function G(w) having a desired characteristic in the frequency domain, and finally by applying on inverse fast Fourier translation (IFFT) of the product $Y(w) = X(w) \cdot G(w)$, an output data sequence y(t) is generated in the time domain. This digital filtering operation, however, cannot take place in real time if the input digital data sequence x(t) occupies a relatively long time. Furthermore, the FFT and IFFT hardware required is very complicated and large.

Another filtering operation uses a convolution algorithm between the input data sequence in the time domain x(t) and an impulse response sequence g(i) (i = 0, 1, ..., m). The convolution algorithm for this filtering operation is expressed as follows:

$$y(t) = \Sigma \ g(i) \cdot x(t-i)$$

where y(t) represents a filtered output digital data sequence.

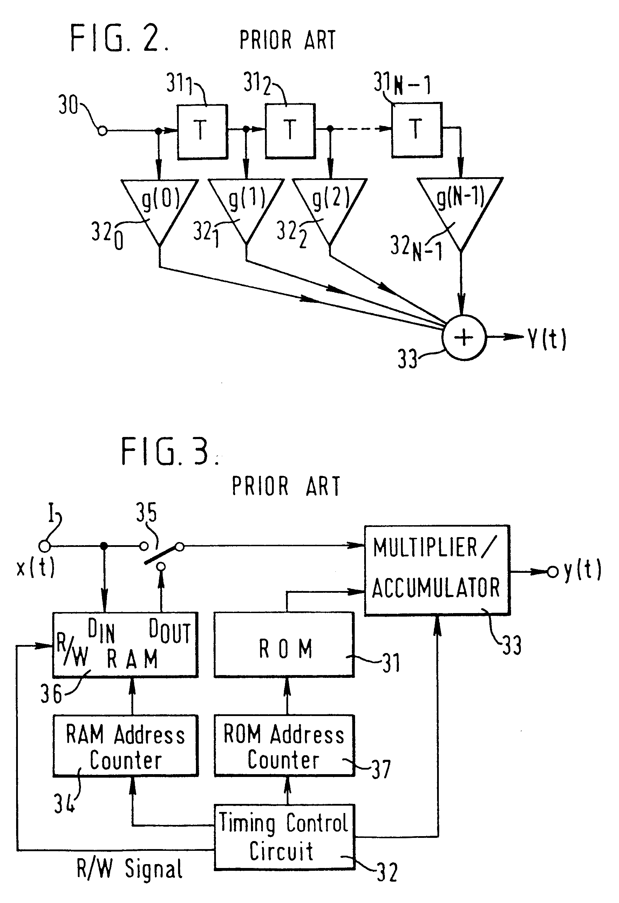

Conventional circuit arrangements for implementing the convolution algorithm are illustrated in Figs. 2 and 3 and have been described in a paper entitled "FIR Filter and Digital signal Processing", Musen to Jikken, Special Edition, issued on November 20, 1979, pp.89-96. The circuit diagram shown in Fig. 2 is a basic arrangement for performing the convolution algorithm. In Fig. 2, input terminal 30 receives a digital data sequence x(t) consisting of a plurality of coded bytes (e.g., of 16 bits per byte) obtained through an analog-to-digital (A/D) conversion of an analog signal at sampling frequency w. The sequence x(t) is fed through a delay device 31 composed of N-1 delay elements $31_1$ through $31_{N-1}$, each imparting a delay time T equal to the sampling period $1/F_S$. The outputs x(t) to x(t-N+1) of the delay elements $31_1$ through $31_{N-1}$

are sent to multipliers $32_0$ through $32_{N-1}$ each having a corresponding filter coefficient g(i) (i = 0, 1, ..., N-1) derived from a desired impulse response or frequency transfer function. The outputs of the multipliers $32_0$ through $32_{N-1}$ are sent to an adder 33 to give a digital output sequence y(t). Such a structure achieves the required filtering characteristics given the appropriate coefficient factors g(i). The circuit shown in Fig. 2, however, requires a large number of delay elements and multipliers to implement a convolution algorithm of higher order.

The circuit in Fig. 3 has been proposed in the previously mentioned November 1979 paper for improving the basic circuit shown in Fig 2, and includes memories for storing an input data sequence x(t) and corresponding filter coefficients g(i). In Fig. 3, the set of coefficient data factors g(k), which are set beforehand, are stored in ROM (read-only memory) 31. These coefficient data factors g(k) are sequentially read from addresses provided by address counter 37 and the coefficient data are fed to multiplier/accumulator 33. The input signal x(t), which constitutes the other data sequence of the convolution arithmetic calculation, is supplied to input I from an external source at prescribed intervals. As shown in the drawing, the input signal x(t) may be applied to multiplier/accumulator 33 through switch 35 or to a data input terminal $D_{IN}$ of RAM (random access memory) 36. Switch 35 determines whether input signal x(t) is fed to multiplier/accumulator 33 directly or is stored in RAM 36 for later presentation to the accumulator. The RAM 36 stores the input signal x(t) at certain prescribed times and is normally in a read mode so as to supply the stored input signals to multiplier/accumulator 33 through switch 35. Both the designation of the operating node (read/write) and the application of addresses to RAM 36 (via RAM Address Counter 34) are carried out by timing control circuit 32 which is operated by a software-driven microcomputer. The timing control circuit 32 also generates addresses for ROM 31 via ROM Address Counter 37 and further controls the operation mode of RAM 36 and the timing of multiplier/accumulator 33.

The calculation of

$$y(t) = \sum_{k=0}^{m} g(2k) \; x(t-k)$$

will be considered to help explain the operation of the circuit shown in Fig. 3. First, timing control circuit 32 and counters 34 and 37 indicate the addresses to enable sequential output of the coefficient data factors g(2), g(4), ..., g(2m) stored in ROM 31 and of the input signals x(t-1), x(t-2), ...x(t-m) stored in RAM 36 according to the proper correspondence between g(2k) x(t-k). These data are supplied to multiplier/accumulator 33 where corresponding elements of both sequences are successively multiplied and the products added. During this time, a R/W (designating read/write) signal from the timing control circuit 32 is at the L (low) level so RAM 36 is in the read mode. The R/W signal is also applied to a control terminal (not shown) of switch 35, so that the path of the input signal x(t) from the external source is disabled.

Before timing control circuit 32 performs the above operation, or at a suitable time during its progress, the R/W signal changes to the H (high) level, putting RAM 36 into the write mode, and setting switch 35 to connect multiplier/accumulator 33 to the external source device so that the current input signal x(t) is fed both to multiplier/accumulator 33 and to RAM 36. Timing control circuit 32 simultaneously identifies the addresses of ROM 31 and RAM 36 so that the coefficient data factor g(k) corresponding to the input signal x(t) is read out from ROM 31 and the current input signal x(t) is stored at the prescribed address in RAM 36 ready for use in the next calculation. When the convolution algorithm

$$y(t) = \sum_{k=0}^{m} g(2k),$$

x(t-k) has been performed, multiplier/accumulator 33 outputs the result of its convolution calculation in response to an output control signal from timing control circuit 32.

Furthermore the article "Digitales FIR-Filter für die Messwertverarbeitung" by H.-J. KOLB in ELEKTRONIK, vol. 32, no. 3, February 1983, pages 85-88 shows in Figure 3 a circuit diagram of a convolution arithmetic circuit for the convolution algorithm being expressed by

$$y(t) = \Sigma \; g(k) . x(t-k)$$

comprising:

first memory means (K-SP) for storing a first data sequence (coefficient data factors g(k));

second memory means (Z̄-SP) for storing a second data sequence x(t);

first counter means (Zähler K̄A-Z) providing cycles of count data, each said cycle including a sequence of non-repeating counts (0 - m);

second counter means (Zähler ZV-Z) providing a series of addresses for said second memory means, each series including a sequence of non-repeating addresses of a number n;

multiplying/accumulating means for computing a series of products by multiplying elements of said first data sequence read from said first memory means by elements of said second data sequence read from said second memory means and for determining the sum of said products.

Thus, the conventional convolution arithmetic circuit involves storing, in prescribed locations in the memory, two sets of data relating to the convolution calculation between the input signal x(t) and the coefficient data g(k), and supplying these sequentially to a multiplier/accumulator in accordance with a correspondence relationship, all these operations being controlled by a programmed microcomputer.

The above conventional convolution arithmetic circuit has a certain flexibility in that it makes use of a programmable microcomputer, but, if it were to be applied as a digital filter in, for example, a DAD system, problems would arise regarding the processing speed of the microcomputer software rendering the convolution arithmetic circuit unable to cope with the data flow.

This problem can have very dire consequences. Specifically, in a digital filter used in a digital recording and playback unit as described above, the input signal x(t) is sampled at the sampling interval before being input sequentially, so the convolution algorithm must be performed in real time. This causes higher order calculation since the sampling frequency of the coefficient data g(k) that is used in the convolution algorithm must be fairly high, due to the need to set a transmission function, i.e., a filter characteristic, for the digital filter that will enable it to deal with signals containing a large number of high-frequency components. Since, as mentioned above, all the address signals and operations must be controlled by the programmed microcomputer, the load on the CPU (central processing unit) of the microcomputer becomes too great to carry out the arithmetical processing in the required time intervals. Such problems increase as the complexity of the calculations increase, and these problems set limits on the signal processing capabilities that can be achieved in practice using such conventional convolution arithmetic systems.

## SUMMARY OF THE INVENTION

One object of the invention is to provide a convolution arithmetic circuit suitable for real-time processing of digital signals.

Another object of the invention is to provide a convolution arithmetic circuit having a simple construction for selecting different convolution formulae for data to be calculated.

A first embodiment of a convolution arithmetic circuit is claimed in Claim 1. A second embodiment of a convolution arithmetic circuit is claimed in Claim 6.

## BRIEF DESCRIPTION OF THE DRAWINGS

Fig. 1 is a block diagram of the essential construction of a prior art digital recording and play-back unit.

Figs. 2 and 3 are circuit diagrams showing convolution arithmetic systems that have been previously proposed.

Fig. 4 is a circuit diagram of an embodiment of a convolution arithmetic circuit according to this invention.

Fig. 5 is a graph showing impulse responses representing coefficient data factors of a digital filter.

Fig. 6a is a timing diagram given in explanation of the operation of the Fig. 4 embodiment in response to select signal U/D being at the H level.

Fig. 6b is a graph showing the relation of ROM addresses to the counts of the system counter, illustrating the operation shown in Fig. 6a.

Fig. 7a is a timing diagram given in explanation of the operation of the Fig. 4 embodiment in response to select signal U/D being at the L level.

Fig. 7b is a graph showing a different relation of ROM addresses to the counts of the system counter, illustrating the operation shown in Fig. 7a.

Fig. 8 is a tabulation of the storage location within ROM 42 (Fig. 4) of the various filtering coefficient data factor values depicted in Fig. 5.

Fig. 9 is a schematic circuit diagram of an alternate embodiment of a convolution arithmetic circuit constructed in accordance with a different aspect of the invention.

Figs. 10 and 11 are diagrams showing the storage locations of the various filter coefficient data factor values stored at the storage locations of ROM 42a and ROM 42b, respectively, as shown in Fig. 9.

Fig. 12 is a timing diagram illustrating the operation of the Fig. 9 embodiment in response to select signal U/D' being at the H level.

Fig. 13 is a timing diagram illustrating the operation of the Fig. 9 embodiment in response to select signal U/D' being at the L level.

## DETAILED DESCRIPTION OF THE EMBODIMENTS

Embodiments of the present invention are described below with reference to the accompanying drawings.

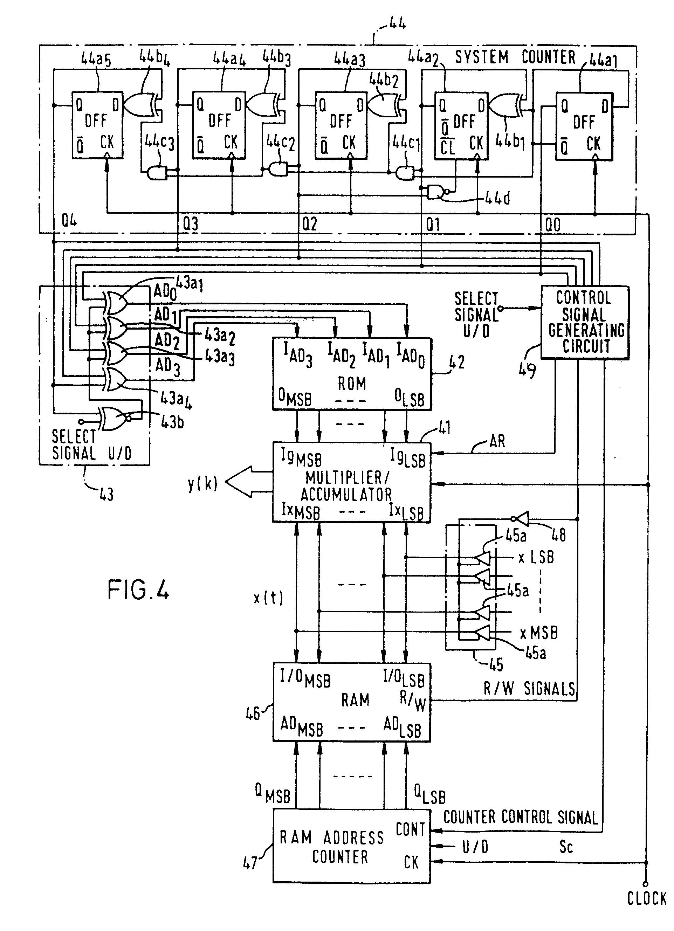

Fig. 4 shows a circuit configuration of an embodiment of a convolution arithmetic circuit according to this invention. In this embodiment, the sampling frequency of the coefficient data g(k) is set at a prescribed value as described hereinafter. In Fig. 4, the set of input terminals $Ig_{LSB}$ to $Ig_{MSB}$ of an accumulator 41 is connected to the set of output terminals $O_{LSB}$ to $O_{MSB}$ of a ROM 42 that stores the coefficient data factors g-(k). Address input terminals $IA_{D0}$ to $IA_{D3}$ of ROM 42 are connected to the output terminals of a system counter 44 through a ROM address altering circuit 43. System counter 44 is a scale-of-24 counter including five D-type flip-flops (DFF) $44a_1$ to $44a_5$ coupled with each other by exclusive-OR (EX-OR) gates $44b_1$ to $44b_4$, AND gates $44c_1$ to $44c_3$ and a NAND gate 44d.

Another set of input terminals $Ix_{LSB}$ to $Ix_{MSB}$ of accumulator 41, to which the multiplicand data are applied receive, with the prescribed timing (to be described subsequently), input signals x(t) (the data of each bit are $x_{LSB}$ to $x_{MSB}$) that are supplied from an external device through a gate 45 that has, arranged in parallel with it, a prescribed number of tri-state buffers 45a, corresponding to each bit. They are also connected to input/output (I/O) terminals $I/O_{LSB}$ to $I/O_{MSB}$ of a RAM 46, which holds a plurality of input signals constituting the multiplicand data. Address signals that are applied to address input terminals $AD_{LSB}$ to $AD_{MSB}$ of RAM 46 are generated by a RAM address counter 47 and supplied from its output terminals $Q_{LSB}$ to $Q_{MSB}$. RAM address counter 47 is a "scale-of-six" counter and may be configured as the RAM address counter described in co-pending European application 84308175.3. A control signal generating circuit 49, also described in that application, is connected to output terminals Q0 to Q4 of system counter 44 for generating a R/W signal, a counter control signal Sc and an accumulator reset signal AR.

The R/W signal specifies the operating mode of RAM 46 and is applied directly to a mode change terminal R/W of RAM 46 and to gate 45 through an inverter 48. The R/W signal, when low (L), changes RAM 46 to a write-mode and permits the supply, to RAM 46 and multiplier/accumulator (M/A) 41, of the input signal x(t) that is then present at the input terminals of the tri-state buffer 45. While the R/W signal is high (H) RAM 46 is in read-mode and permits the supply, to M/A 41, of the signal stored in RAM 46. Gate 45 is disabled to prohibit the passage of the input signals x(t) to the input of M/A 41.

The counter control signal Sc is applied to a control terminal of RAM address counter 47 and changes the count mode of RAM address counter 47 in response to the state of the counter control signal Sc. RAM address counter 47 performs an ordinary counter operation, i.e., incrementing the count by 1 with every CLOCK signal, while the counter control signal Sc is at level L. However, when the counter control signal Sc is at level H the count of RAM address counter 47 is incremented by +2 for each CLOCK signal.

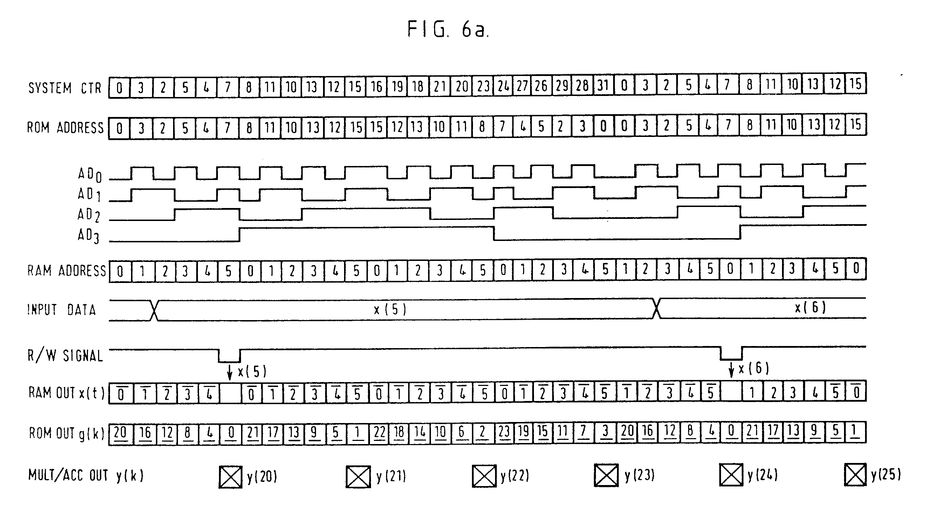

Since counter 44 is a scale-of-24 counter it has a 24-count sequence as follows: 0, 3, 2, 5, 4, 7, 8, 11, 10, 13, 12, 15, 16, 19, 18, 21, 20, 23, 24, 27, 26, 29, 28, 31. This sequence automatically repeats itself as long as clock pulses are applied. This is represented in the SYSTEM COUNTER line of Fig. 6a.

ROM address altering circuit 43 includes four EX-OR gates $43a_1$ to $43a_4$ and an inverted EX-OR gate 43b. Inverted EX-OR gate 43b receives the output Q4 of system counter 44 and a select signal U/D. The control signal U/D is also applied to control signal generating circuit 49. EX-OR gate $43a_4$ also receives the output Q4 and receives as a second input the second most significant bit output Q3 of system counter 44. The rest of EX-OR gates $43a_1$ to $43a_3$ receive respectively the outputs Q0 to Q2 of system counter 44 as well as the output of inverted EX-OR gate 43b. Outputs $AD_0$ to $AD_3$ of EX-OR gates $43a_1$ to $43a_4$ are respectively applied to input terminals $IAD_0$ to $IAD_3$ of ROM 42. When the output of X-OR 43b is "1", EX-OR's $43a_1$-$43a_4$ invert the Q0-Q3 outputs from counter 44. When EX-OR 43b is "0" the Q0-Q3 counter outputs are passed unchanged. As a result, the second twelve count states represented by the $AD_0$-$AD_3$ signals are a "mirror image" of the first twelve $AD_0$-$AD_3$ count states. This is illustrated in the "ROM ADDRESS" line of Fig. 6a.

## OPERATION

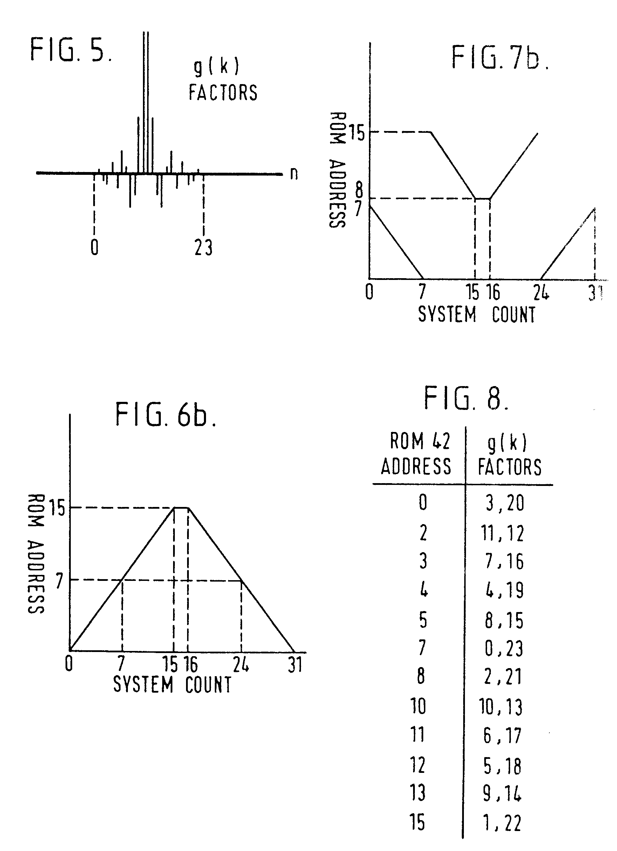

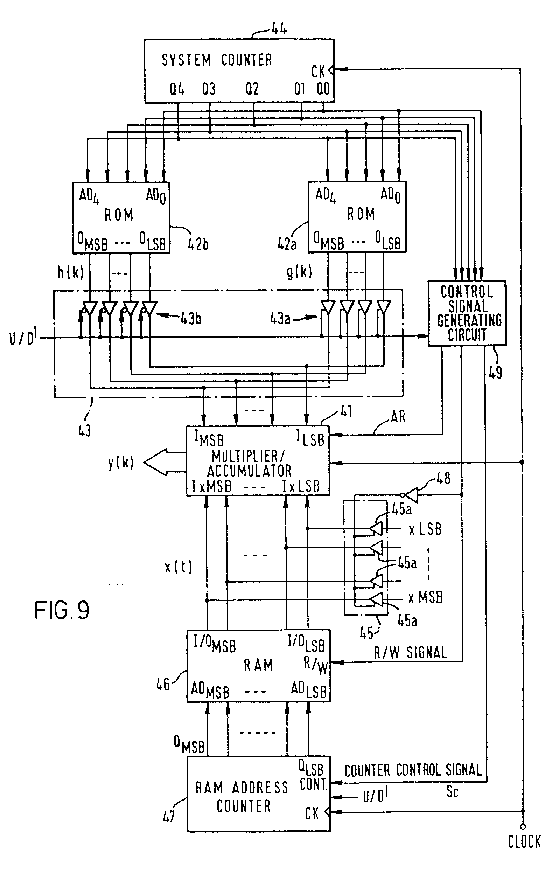

The operation of the system will now be explained with reference to Figs. 4-7b. ROM 42 stores twelve coefficient data factors g(k). However, twenty-four coefficient data factors are necessary for one convolution processing cycle in digital filtering. As shown in Fig. 5, the impulse response values 0-23 comprising the coefficient data factors present a symmetrical pattern such that each response in a symmetrical half is the same in amplitude as a corresponding one in the opposite symmetrical half. Accordingly, impulse response factors for one symmetrical half, in this case twelve impulse responses from the center of the symmetrical pattern, represent the coefficient data factors g(k) stored in ROM 42. The twenty-four coefficient data factors are stored at ROM addresses 0, 3, 2, 5, 4, 7, 8, 11, 10, 13, 12 and 15 as shown in Fig. 8.

The outputs $AD_0$ to $AD_3$ of address altering circuit 43 respectively change as shown by signal waveforms $AD_0$ to $AD_3$ in Fig. 6a. The relationship of $AD_0$-$AD_3$ to the count of system counter 44 is indicated by comparing the SYSTEM CTR line of Fig. 6a with $AD_0$-$AD_3$. The ROM addresses generated by the outputs $AD_0$ to $AD_3$ for ROM 42 change as shown in the ROM address line of Fig. 6a. The relationship between the ROM addresses and the count of system counter 44 is represented by the diagram shown in Fig. 6b. Each of the ROM addresses 0 to 15 is generated twice in a cycle of the system counter 44 from 0 to 31. The twelve coefficient data factors g(k) corresponding to the ROM addresses 0-15 are therefore read out and supplied to M/A 41 twice during one cycle of the count of system counter 44. First the coefficient data factors g(k) corresponding respectively to the ROM addresses 0 to 15 are read in turn for the count of 0 to 15 and then the coefficient data factors g(k) corresponding to the ROM ADDRESSES 15 to 0 are read in turn for the count of 16 to 31.

On the other hand, the input signal x(t) is applied to input terminals $Ix_{MSB}$ to $Ix_{LSB}$ of MA 41 from the RAM 46 or from an external device through gate 45. The convolution operation for the coefficient data g(k) and the input signal x(t) at M/A 41 is performed under control of the R/W signal and the counter control signal Sc generated from control signal generating circuit 49. The convolution arithmetic circuit of Fig. 4 increases the effective sampling frequency by a factor of 4 by performing calculations defined by the following equations in response to an H level U/D signal:

$$y(4t) = \sum_{j=0}^{5} g(4j) \cdot x(t-j)$$

$$y(4t+1) = \sum_{j=0}^{5} g(4j+1) \cdot x(t-j)$$

$$y(4t+2) = \sum_{j=0}^{5} g(4j+2) \cdot x(t-j)$$

$$y(4t+3) = \sum_{j=0}^{5} g(4j+3) \cdot x(t-j)$$

The convolution operation is executed four times while the input signal x(t) is sampled once, thereby making the effective sampling frequency of the output data y(t) four times the sampling frequency of the input signal x(t). Actually, the variable $(4t + \alpha)$ of the output $y(4t + \alpha)$ (where = 0, 1, 2, 3) of the above equations is on the time domain, so the output data is, in fact, $y(^{4t + \alpha})$ with respect to the input data x(t), although the variable is expressed for convenience in integer form i.e., in the former form $y(4t + \alpha)$.

This convolution operation is described in connection with the timing diagram shown in Fig. 6a. Input signals received prior to x(5) are omitted. Each time the system counter reaches count "7" R/W signal goes to L to sample the next x(t) input and write it into RAM 46 while also supplying it to multiplier/accumulator 41. System counter 44 counts up in synchronism with the rising edge of the input clock signal CLOCK and the ROM address for ROM 42 changes from 0, 3, 2, ..., 15, and then from 15, 12 ..., 0 in accordance with the count of system counter 44 as mentioned before. With the same timing, the output of RAM address counter 47 is applied to address terminals $AD_{LSB}$ to $AD_{MSB}$ of RAM 46 to change its address (RAM address) from 0, 1, ..., 5, 0, 1, ...5. In this case, the twelve data factors g(20), g(16), g(12), g(8), g(4) g(0), g(21), g(17), g(13), g(9), g(5), and g(1) (expressed as $\underline{20}$, $\underline{16}$, etc. in Fig. 6a) which are stored in ROM 42 at the ROM addresses 0, 3, 2, 5, 4, 7, 8, 11, 10, $\overline{13}$, $\overline{12}$, 15, respectively, are read out forward and backward sequentially. The multiplicand data x(0) to x(4), expressed by $\overline{0}$-$\overline{4}$, respectively, in the RAM OUT line of Fig, 6a, correspond to these coefficient data, and are stored in the RAM 46 at addresses 0 to 4 and are read out from RAM 46.

Multiplier/accumulator (M/A) 41 sequentially calculates the products of these coefficient data and multiplicand data and keeps a running total of the products. M/A 41 thus calculates g(20)$^{\bullet}$x(0) + g(16)$^{\bullet}$x(1) + .... + g(4)$^{\bullet}$x(4), etc.

While the count of system counter 44 is between "0" and "4", the R/W signal is at the H level. When the count of system counter 44 reaches "7", H level outputs $Q_0$ to $Q_2$ of system counter 44 are applied to control signal generating circuit 49, and the R/W signal switches to the L level, causing RAM 46 to change to write-mode and gate 45 in the high impedance state to be opened to allow the most recent input signal x(5) presently at the input of gate 45 to be written in the RAM address "5" of RAM 46.

The input signal x(5) is also supplied to M/A 41 in place of the output of RAM 46, and the input signal x(5) is multiplied by the coefficient data factor g(0) corresponding to the ROM address "7" and present at the ROM output. In this way, M/A 41 makes the final calculation for calculating the output data y(20) corresponding to the input signal x(5).

After the output data y(20) has been calculated, the R/W signal changes to the H level and RAM 46 returns to the read-mode. The read-mode resumes until the count of system counter 44 becomes "8". When this happens, the RAM addresses shift through 0, 1, ..., 5 under control of RAM address counter 47, causing the multiplicand data x(0), x(1), ...., x(5) corresponding to the RAM addresses to be read, the input signal x(5) in the preceding cycle having already been stored in the RAM address "5." The corresponding coefficient data factors g(21), g(17), g(13), g(9), g(5) and g(1) whose ROM addresses 8, 11, 10, 13, 12 and 15 are outputted from ROM 42, so multiplier/accumulator 41 calculates g(21)$^{\bullet}$x(0) + g(17)$^{\bullet}$x(1) + ... + g-(1).x(5). When the count of system counter 44 is "15", i.e., when the outputs $Q_0$ to $Q_2$ of system counter 44 again have become all H level, the accumulating output is latched to hold the output data

$$ y(21) = \sum_{j=0}^{5} g(4j+1).x(5-j). $$

These operations are carried out continuously. While the count of the system counter 44 is shifting from "16" through "23", the coefficient data factors g(22), g(18), ...., g(2) stored at ROM addresses 15, 12, ...., 8 are read out from ROM 42, and the multiplicand data x(0)-x(5) are read out from RAM 46 again in accordance with the address specified by RAM counter 47. M/A 41 therefore calculates g(22).x(0) + g(18)-$^{\bullet}$x(1) + .... + g(2)$^{\bullet}$x(5) with the same timing as in the preceding stage, and delivers the output data

$$ y(22) = \sum_{j=0}^{5} g(4j+2)\cdot x(5-j). $$

These operations are also carried out continuously for the coefficient data factors g(23), g(19), ...g(3) and the multiplicand data x(0)-x(5) while the count of system counter 44 is shifting from "24" through "31", and the output data y(23) = g(4j+3)$^{\bullet}$x(5-j) is produced.

In the above convolution operation, when the count system counter 44 is "31", all of the outputs Q0 to Q4 of system counter 44 become H level. The counter control signal Sc generated from control signal generating circuit 49 changes to the H level. Consequently, in RAM address counter 47, the next RAM address is incremented by +2 with respect to the previous address, shifting from "5" to "1."

In the following convolution calculation, therefore, while the ROM address counts shift from 0 through 4, the RAM address shifts from 1 to 5. Further, when the count of system counter 44 becomes "7", the R/W signal goes to the L level, and the next input signal x(6) is fed to RAM 46 and is stored at RAM address 0. Input x(6) is also fed to M/A 41. Multiplier/accumulator 41 therefore receives as its inputs the coefficient data factors g(20), g(16), ....g(0) and the multiplicand data x(1), x(2), ..., and x(6). M/A 41 calculates g(20)$^{\bullet}$x-(1) + g(16)$^{\bullet}$x(2) + .... + g(0)$^{\bullet}$x(6), and delivers the output data y(24) = g(4j)$^{\bullet}$ x(6-j). For the succeeding calculations, the most recent input signal x(6) is stored in RAM 46 in place of the oldest data x(0). Thus, the

7

multiplicand data read out from RAM 46 are the five most recently recieved input data bytes stored as of the time the count of the system counter 44 became "7."

After calculating the output data y(24) as above, the same sequence of operations occurs as when the series of convolution calculations was performed using the input signal x(6) and the coefficient data read out from the corresponding ROM addresses. The corresponding RAM addresses are repeated in the cycle 1, 2, ..., 5, 0 every time the convolution calculation is performed in each of the stages until the count of system counter 44 again reaches "31." The multiplicand data are therefore successively read out as x(1), x(2), ...., x(6). Accumulator 41 performs the convolution calculation with x(6) as the most recent multiplicand data. The outputs

$$y(25) = \sum_{j=0}^{5} g(4j+1) \cdot x(6-j), \quad y(26) = \sum_{j=0}^{5}$$

$$g(4j+2) \cdot x(6-j), \quad \text{and} \quad y(27) = \sum_{j=0}^{5} g(4j+3) \cdot x(6-j)$$

are obtained when the count of system counter 44 reaches "15", "23", and "31", respectively.

When the count of system counter 44 again becomes "31" the counter control signal Sc changes to H level and the RAM address shifts from "0" to "2." When the count of system counter 44 becomes "7", the R/W signal goes to the L level and the most recent data x(7) is written in the RAM address "1" in place of the oldest multiplicand date x(1). Subsequent operation repeats the operation as previously described. The RAM address shifts by 1 every time the input signals x(t) are successively processed. The convolution algorithm is executed four times with the respective input signal constituting the most recent multiplicand data in each case.

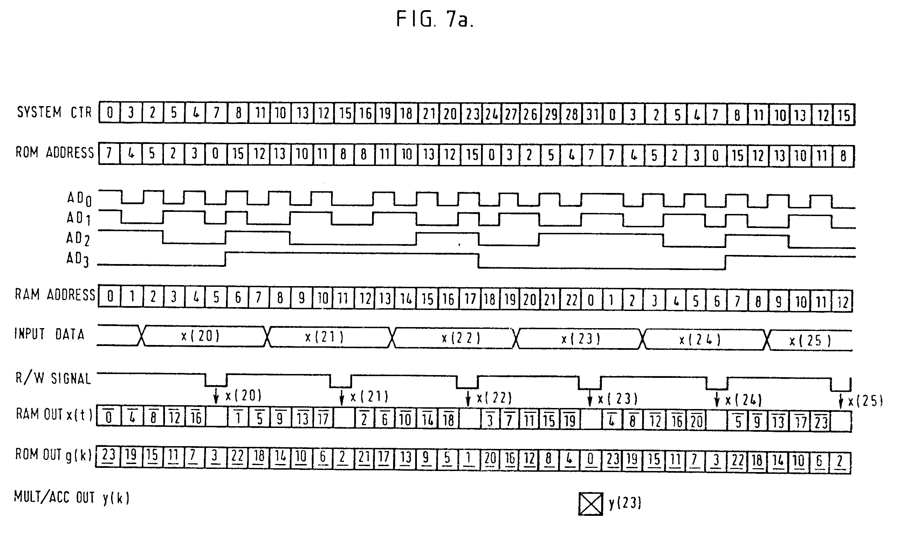

The operation of the convolution circuit of Fig. 4 with the select signal U/D being at the L level is explained hereinafter with respect to the modified operation illustrated in Figs. 7a and 7b. The outputs $AD_0$ to $AD_3$ of address altering circuit 43 respectively change as shown in Fig. 7a according to the count illustrated in the SYSTEM CTR line. The ROM addresses produced by the outputs $AD_0$ to $AD_3$ change as shown in Fig. 7a at ROM Address. The relation of the ROM addresses with the count of system counter 44 is represented in the diagram of Fig. 7b. Each of the ROM addresses 0 to 15 is designated twice in a cycle of the count of system counter 44 from 0 to 31 similar to the cycle shown in Fig. 6b for the case when the select signal U/D is at the H level. But, the ROM addresses corresponding to the counts 0 to 7, 8 to 15, 16 to 23, and 24 to 31 in this case are replaced respectively with the ROM addresses corresponding to the counts 24 to 31, 16 to 23, 8 to 15, and 0 to 7 in the graph of Fig. 6b. The twelve coefficient data factors g(0) to g(11) are therefore read out and supplied to M/A 41 twice during one cycle of the count of system counter 44, according to the order of the ROM addresses as shown in the timing diagram of Fig. 7a. The U/D signal switches the RAM address counter to a "scale-of-23" counter that continuously cycles through a count of 0-22 (decimal equivalent) and repeats, as shown in Fig. 7a. Control signal $S_c$ does not function when U/D is at the low level.

The input signal x(t) is applied to input terminals $Ix_{MSB}$ to $Ix_{LSB}$ of M/A 41 from RAM 46 or an external device through gate 45. The convolution operation for the coefficient data g(k) and the input signal x(t) at M/A 41 is performed under control of the R/W signal and the counter control signal Sc generated from RAM control circuit 49. The convolution arithmetic circuit of Fig. 4 decreases the effective sampling frequency by a factor of 1/4 when the select signal U/D is at the L level, performing calculations defined by the following equations:

$$y(4t-1) = \sum_{j=0}^{23} g(t) \cdot x(4j-1-t)$$

The convolution operation is executed one time while the input signal x(t) is sampled four times, thereby making the effective sampling frequency of the output data y(t) one-fourth of the sampling

8

EP 0 156 648 B1

frequency of the input signal x(t). Actually, the variable (4t - 1) of the output date y(4t - 1) of the above equations is in the time domain, so the output data is, in fact, $y(^{4t-1})$ with respect to the input data x(t), although the variable is expressed for convenience in integer form, i.e., in the former form y(4t - 1).

This convolution is described with reference to the time-chart shown in Fig. 7a. The input signal prior to the stage of x(20) is partially omitted. System counter 44 counts up in synchronism with the rising edge of the input clock signal CLOCK and the address (sequence) for ROM 42 changes as shown in Fig. 7a at "ROM address." In this case, control signal generating circuit 49 changes the R/W signal to the L level every time system counter 44 advances six counts, i.e., 0 to 7, 8 to 15, etc., due to the select signal U/D being at the L level. Then, the input signals x(20), x(21), x(23) ...are stored continuously in RAM 46 at the respective RAM addresses "5", "11", "17" ... in place of the oldest data stored there. On the other hand, accumulator 41 delivers its convolution output when the timing system counter 44 reaches a count of "31". That is, accumulator 41 delivers:

$$
\begin{aligned}
y(23) = \ & g(23) \cdot x(0) + g(19) \cdot x(4) + g(15) \cdot x(8) + g(11) \cdot x(12) \\
& + g(7) \cdot x(16) + g(3) \cdot x(20) + g(22) \cdot x(1) + g(18) \cdot x(5) \\
& + g(14) \cdot x(9) + g(10) \cdot x(13) + g(6) \cdot x(17) + g(2) \cdot x(21) \\
& + g(21) \cdot x(2) + g(17) \cdot x(6) + g(13) \cdot x(10) + g(9) \cdot x(14) \\
& + g(5) \cdot x(18) + g(1) \cdot x(22) + g(20) \cdot x(3) + g(16) \cdot x(7) \\
& + g(12) \cdot x(11) + g(8) \cdot x(15) + g(4) \cdot x(19) + g(0) \cdot x(23)
\end{aligned}
$$

The detailed explanation of Fig. 7a for the operation during the select signal U/D being at the L level is omitted hereunder inasmuch as its operation may be understood from the explanation given above in connection with Fig. 6a, taking into consideration the above-mentioned basic differences in the count sequences and sampling frequency.

Figs. 9-13 illustrate an alternate embodiment employing a different aspect of applicants' invention. The system shown in Fig. 9 employs a multiplier/accumulator 41, a RAM 46, RAM address counter 47, control signal generating circuit 49, and a system counter 44 identical to those same components shown and described above in connection with the Fig. 4 embodiment.

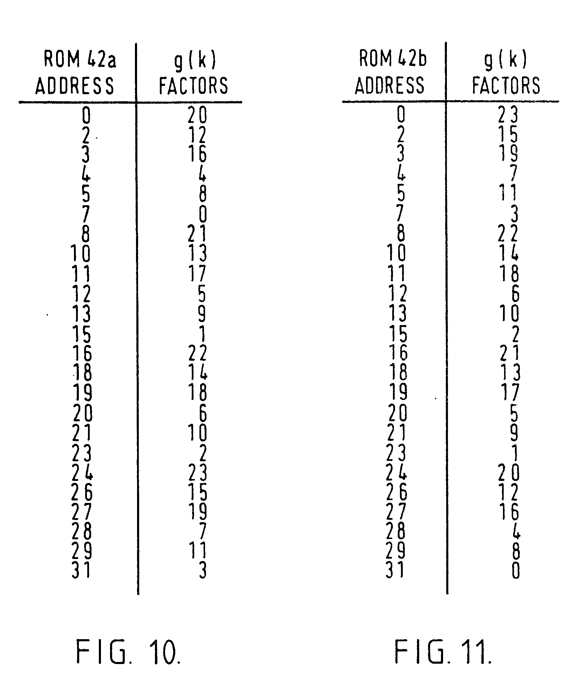

However, instead of employing a single ROM, the Fig. 9 system employs a pair of ROMs 42a and 42b. Further, the count conversion circuit 43 employed in the Fig. 4 system is not utilized and, instead, the five output lines Q0-Q4 of scale-of-24 counter 44 are fed directly to the address inputs $AD_0$-$AD_4$ of the ROMs 42a and 42b. Accordingly, the ROMs are simultaneously addressed with a continuous sequence of 5-bit address signals progressing in accordance with the normal counter sequence of scale-of-24 counter 44. Each address signal presented to the ROMs 42a, 42b reads out of the accessed storage location one of the filter coefficient data factors stored therein. The data factor values stored in the ROMs are the same as those depicted in connection with Fig. 5. However, all 24 data factors 0-23 are stored at individual storage locations in each of the ROMs. Fig. 10 shows the storage locations of ROM 42a and the particular g(k) factor stored therein. Fig. 11 shows the storage locations of ROM 42b and the particular g(k) data factor stored therein.

Selection signal U/D' shown in Fig. 9 operates a pair of gate circuits 43a and 43b to activate either the outputs from ROM 42a or the outputs from ROMs 42b, depending upon the state (H or L) of the U/D' signal. When U/D' is high, gates 43a are enabled such that the outputs from ROM 42a are fed to the inputs $I_{LSB}$-$I_{MSB}$ of multiplier/accumulator 41 in response to the progression of system counter 44. Gates 43b are disabled and the outputs from ROM 42b are not utilized. However, when U/D' is at the L level, the opposite condition prevails and the outputs from ROM 42b are fed to the inputs $I_{LSB}$-$I_{MSB}$ of multiplier/accumulator 41.

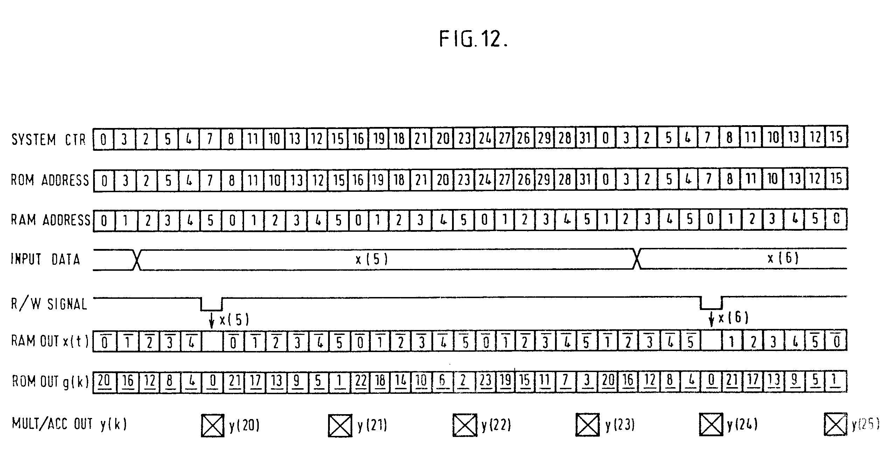

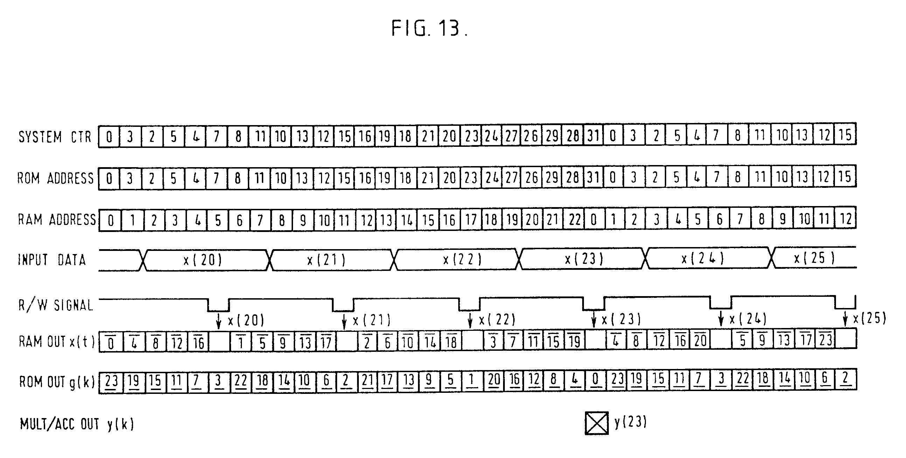

As shown in Figs. 12 and 13, the system operation achieved by the circuit of Fig. 9 is identical with the operation achieved in the circuit of Fig. 4 for the two states of the U/D signal. When the U/D' is at the H level, the Fig. 9 system performs digital filtering at the high sampling rate identically with the operation previously described in connection with Fig. 6a. While the operation depicted in Fig. 12 indicates that the ROM addresses sequence in sync with the outputs of the system counter, the outputs from the ROM 42a are exactly the same as the ROM outputs of the Fig. 4 system (Fig. 6a), whereupon the same filtering

9

function and sampling rate operation are achieved.

When U/D' of the Fig. 9 system is at the L level, operation identical to that previously described in connection with Fig. 7a is achieved. Again, as shown in Fig. 13, the sequence of ROM addresses is synched to the output of system counter 44 but since the filtering coefficient data factors stored in ROM 42b produce a ROM output identical to that illustrated in connection with Fig. 7a, the identical low sampling frequency operation previously described in connection with Fig. 7a is achieved. As shown in Fig. 13, the RAM address counter 46 functions as a "scale-of-23" counter at this time, just as in the case of the operation depicted in Fig. 7a.

## Claims

1. A convolution arithmetic circuit comprising:
   first memory means (42) for storing as a first data sequence the coefficient data factors;
   second memory means (46) for storing a second data sequence determined from an input signal;
   first counter means (44) providing cycles of count data, each said cycle including a sequence of non-repeating counts;
   second counter means (47) providing a series of addresses for said second memory;
   multiplying/accumulating means (41) for computing a series of products by multiplying elements of said first data sequence read from said first memory means, by elements of said second data sequence read from said second memory means and determining the sum of said products;
   characterised in that said second counter means (47) has either a first-count sequence if a select signal (U/D) has a first state, or a second-count sequence if said select signal has a second state, and
   in that the convolution arithmetic circuit further comprises:
   transformation means (43) for transforming each said cycle of said count data into a series of addresses for said first memory means, each said series including a sequence wherein at least one address is generated twice and wherein the or each address of the first memory means which is generated twice in a cycle of count data stores a data value which appears twice in the data sequence which is generated by each cycle of count data; and
   selection means comprising:
   means (49) for altering the count cycles of the second counter means; said altering means (49) providing a control signal ($S_c$) for increasing the count of the second counter means by two instead by one when said select signal is in the first state and the first counter means has a predetermined value; and
   means (43b) for altering the order of said series of addresses generated for said first memory, by affecting the transformation effected by said transformation means under control of said select signal;
   such that the effective sampling frequency of the data computed by the multiplying/accumulating means is a multiple or submultiple of the sampling frequency of the second data sequence.

2. A convolution arithmetic circuit of claim 1 wherein said transformation means (43) includes means for providing said series of addresses such that each address occurs twice during one cycle of the count data.

3. A convolution arithmetic circuit of claim 2 wherein said transformation means (43) further includes means for providing said series of addresses such that during one cycle of said count data a first address sequence is generated and is then repeated in reverse order.

4. A convolution arithmetic circuit according to one of claims 1 to 3 wherein the means (49) for altering the count cycles of the second counter means comprises means for generating said control signal.

5. A convolution arithmetic circuit as claimed in claim 4 wherein said address order altering means (43b) and said control signal generating means operate synchronically.

6. A convolution arithmetic circuit comprising:
   first memory means (42a) for storing a first data sequence;
   second memory means (46) for storing a second data sequence determined from an input signal;
   first counter means (44) providing a cyclical series of first addresses;
   second counter means (47) providing a cyclical series of second addresses for said second memory means;

EP 0 156 648 B1

multiplying/accumulating means (41);

characterised in that said second counter means (47) has either a first-count sequence if a select signal (U/D) has a first state, or a second-count sequence if said select signal has a second state, and in that the convolution arithmetic circuit also comprises; third memory means (42b) for storing a third data sequence: the third memory means also being supplied with addresses by the first counter means; each said first and third data sequences being coefficient data factors;

selection means (43) for selectively supplying under control of said select signal an output representing either said first or said third data sequence read from said first or third memory means in response to said first addresses;

means (49) for altering the count cycles of the second counter means, said altering means (49) providing a control signal ($S_c$) for increasing the count of said second counter means by two instead by one when said select signal is in a first state and the first counter means has a predetermined value;

in that said multiplying/accumulating means (41) computes a series of products by multiplying elements of said second data sequence, read from said second memory, by said data sequence supplied by said selection means, and determines the sum of said products; and

in that each element of the data sequence supplied by the selection means from the first or third memory means is read from a unique location in said memory means; and

in that the effective sampling frequency of the data computed by the multiplying/accumulating means is a multiple or a submultiple of the sampling frequency of the second data sequence.

**Patentansprüche**

1.  Arithmetische Konvolutionsschaltung, die umfaßt:

ein erstes Speichermittel (42) zum Speichern der Koeffizientendatenfaktoren als eine erste Datensequenz,

ein zweites Speichermittel (46) zum Speichern einer zweiten Datensequenz, die aus einem Eingangssignal bestimmt ist,

ein erstes Zählmittel (44), das Zyklen von Zähldaten erzeugt, wobei jeder Zyklus eine Sequenz von sich nicht wiederholenden Zählständen enthält,

ein zweites Zählmittel (47), das eine Reihe von Adressen für den zweiten Speicher erzeugt,

ein Multiplizierungs-/Akkumulierungsmittel (41) zum Berechnen einer Reihe von Produkten durch Multiplizieren von Elementen der ersten Datensequenz, die aus dem ersten Speichermittel ausgelesen ist, mit Elementen der zweiten Datensequenz, die aus dem zweiten Speichermittel ausgelesen ist, und zum Bestimmen der Summe der Produkte,

**dadurch gekennzeichnet,** daß das zweite Zählmittel (47) entweder eine Erstzählsequenz hat, wenn ein Auswahlsignal (U/D) einen ersten Zustand aufweist, oder eine Zweitzählsequenz, wenn das Auswahlsignal einen zweiten Zustand aufweist, und daß die arithmetische Konvolutionsschaltung ferner umfaßt:

ein Umsetzungsmittel (43) zum Umsetzen jedes Zyklus der Zähldaten in eine Reihe von Adressen für das erste Speichermittel, wobei jede Reihe eine Sequenz enthält, worin zumindest eine Adresse zweimal erzeugt wird und wobei die oder jede Adresse des ersten Speichermittels, die zweimal in einem Zyklus von Zähldaten erzeugt ist, einen Datenwert speichert, der zweimal in der Datensequenz auftritt, die durch jeden Zyklus der Zähldaten erzeugt wird, und

ein Auswahlmittel, das enthält:

ein Mittel (49) zum Ändern der Zählzyklen des zweiten Zählmittels, wobei das Änderungsmittel (49) ein Steuersignal ($S_c$) zum Erhöhen des Zählstandes des zweiten Zählmittels um zwei statt um eins vorsieht, wenn sich das Auswahlsignal in dem ersten Zustand befindet und das erste Zählmittel einen vorbestimmten Wert hat, und

ein Mittel (43b) zum Ändern der Ordnung der Reihe von Adressen, die für den ersten Speicher erzeugt sind, durch Beeinflussen der Umsetzung, die durch das Umsetzungsmittel bewirkt wird, unter Steuerung durch das Auswahlsignal, so daß die effektive Abtastfrequenz der Daten, die durch das Multiplizierungs-/Akkumulierungsmittel berechnet sind, ein Vielfaches oder ein in einer Zahl enthaltener Faktor der Abtastfrequenz der zweiten Datensequenz ist.

2.  Arithmetische Konvolutionsschaltung nach Anspruch 1, bei der das Umsetzungsmittel (43) ein Mittel zum Erzeugen der Reihe von Adressen in einer Weise enthält, daß jede Adresse zweimal während eines Zyklus der Zähldaten auftritt.

11

**3.** Arithmetische Konvolutionsschaltung nach Anspruch 2, bei der das Umsetzungsmittel (43) ferner ein Mittel zum Erzeugen der Reihe von Adressen in einer Weise enthält, daß während eines Zyklus der Zähldaten eine erste Adressensequenz erzeugt und dann in umgekehrter Ordnung wiederholt wird.

**4.** Arithmetische Konvolutionsschaltung nach einem der Ansprüche 1 bis 3, bei der das Mittel (49) zum Ändern der Zählzyklen des zweiten Zählmittels ein Mittel zum Erzeugen des Steuersignals umfaßt.

**5.** Arithmetische Konvolutionsschaltung nach Anspruch 4, bei der das Adressenordnungs-Änderungsmittel (43b) und das Steuersignal-Erzeugungsmittel synchron arbeiten.

**6.** Arithmetische Konvolutionsschaltung, die umfaßt: ein erstes Speichermittel (42a) zum Speichern einer ersten Datensequenz,

ein zweites Speichermittel (46) zum Speichern einer zweiten Datensequenz, die aus einem Eingangssignal bestimmt ist, ein erstes Zählmittel (44), das eine zyklische Reihe von ersten Adressen erzeugt,

ein zweites Zählmittel (47), das eine zyklische Reihe von zweiten Adressen für das zweite Speichermittel erzeugt, ein Multiplizierungs-/Akkumulierungsmittel (41),

**dadurch gekennzeichnet,**

daß das zweite Zählmittel (47) entweder eine Erstzählsequenz hat, wenn ein Auswahlsignal (U/D) einen ersten Zustand aufweist, oder eine Zweitzählsequenz, wenn das Auswahlsignal einen zweiten Zustand aufweist, und

daß die arithmetische Konvolutionsschaltung ferner umfaßt: ein drittes Speichermittel (42b) zum Speichern einer dritten Datensequenz, welches dritte Speichermittel ebenfalls durch das erste Zählmittel mit Adressen versorgt wird, wobei jede der ersten und dritten Datensequenzen Koeffizientdatenfaktoren sind,

ein Auswahlmittel (43) zum wahlweisen Liefern unter Steuerung des Auswahlsignals eines Ausgangssignals, das entweder die erste oder die dritte Datensequenz repräsentiert, die aus dem ersten oder dem dritten Speichermittel in Reaktion auf die ersten Adressen ausgelesen sind,

ein Mittel (49) zum Ändern der Zählzyklen des zweiten Zählmittels, wobei das Änderungsmittel (49) ein Steuersignal ($S_c$) zum Erhöhen des Zählstandes des zweiten Zählmittels um zwei statt um eins erzeugt, wenn sich das Auswahlsignal in einem ersten Zustand befindet und das erste Zählmittel einen vorbestimmten Wert aufweist,

daß das Multiplizierungs-/Akkumulierungsmittel (41) eine Reihe von Produkten durch Multiplizieren von Elementen der zweiten Datensequenz, die aus dem zweiten Speicher ausgelesen ist, mit der Datensequenz, die durch das Auswahlmittel zugeführt ist, berechnet und die Summe der Produkte bestimmt, daß jedes Element der Datensequenz, die durch das Auswahlmittel von dem ersten oder dem dritten Speichermittel zugeführt wird, aus einem eindeutig bestimmten Speicherplatz in dem Speichermittel ausgelesen wird, und

daß die effektive Abtastfrequenz der Daten, die durch das Multiplizierungs-/Akkumulierungsmittel berechnet sind, ein Vielfaches oder ein in einer Zahl enthaltener Faktor der Abtastfrequenz der zweiten Datensequenz ist.

**Revendications**

**1.** Circuit arithmétique de convolution comprenant :

des premiers moyens de mémoire (42) pour stocker à titre de première séquence de données les facteurs servant de données de coefficients ;

des seconds moyens de mémoire (46) pour stocker une seconde séquence de données déterminée par un signal d'entrée ;

des premiers moyens de comptage (44) produisant des cycles de données de comptages, chaque dit cycle incluant une séquence de comptages non répétitif ;

des seconds moyens de comptage (47) produisant une série d'adresses pour ladite seconde mémoire ;

des moyens multiplicateurs accumulateurs (41) pour calculer une série de produits par multiplication des éléments de ladite première séquence de données lues sur lesdits premiers moyens de mémoire, par les éléments de ladite seconde séquence de données lues sur lesdits seconds moyens de mémoire et pour déterminer la somme desdits produits ;

caractérisé en ce que lesdits seconds moyens de comptage (47) présentent une première séquence de comptage si un signal de sélection U/D présente un premier état, ou une seconde séquence de comptage si ledit signal de sélection présente un second état ; et en ce que le circuit arithmétique de convolution comporte de plus :

des moyens de transformation (43) pour transformer chaque cycle desdites données de comptage en une série d'adresses destinées auxdits premiers moyens de mémoire, chacune desdites séries comprenant une séquence dans laquelle au moins une adresse est générée deux fois et dans laquelle chacune des adresses des premiers moyens de mémoire qui est générée deux fois au cours d'un cycle des données de comptage, stocke une valeur de donnée qui apparaît deux fois dans la séquence des données qui est générée pour chaque cycle des données de comptage ; et

des moyens de sélection comprenant :

des moyens (49) pour changer les cycles de comptage des seconds moyens de comptage ; lesdits moyens (49) pour changer les cycles de comptage produisant un signal de commande (Sc) pour augmenter le comptage des seconds moyens de comptage d'un facteur de 2 au lieu de 1 quand ledit signal de sélection est dans le premier état et que les premiers moyens de comptage présentent une valeur prédéterminée ; et

des moyens (43b) pour changer l'ordre de ladite série des adresses générée pour lesdits premiers moyens de mémoire en modifiant la transformation effectuée par lesdits moyens de transformation sous le contrôle dudit signal de sélection ;

de telle sorte que la fréquence d'échantillonnage efficace des données calculées par les moyens multiplicateurs/accumulateurs soit un multiple ou un sous- multiple de la fréquence d'échantillonnage de la seconde séquence de données.

2. Circuit arithmétique de convolution selon la revendication 1, dans lequel lesdits moyens de transformation (43) comportent des moyens pour produire ladite série des adresses de telle sorte que chaque adresse apparaît deux fois pendant un seul cycle des données de comptage.

3. Circuit arithmétique de convolution selon la revendication 2, dans lequel lesdits moyens de transformation (43) comportent de plus des moyens pour produire ladite série des adresses de telle sorte que pendant un seul cycle desdites données de comptage, une première séquence d'adresses est générée et ensuite répétée dans l'ordre inverse.

4. Circuit arithmétique de convolution selon l'une des revendications 1 à 3, dans lequel les moyens (49) pour changer les cycles de comptage des seconds moyens de comptage comportent des moyens pour générer ledit signal de commande.

5. Circuit arithmétique de convolution selon la revendication 4, dans lequel lesdits moyens pour changer l'ordre d'adressage (43b) et lesdits moyens générateurs du signal de commande fonctionnent en synchronisme.

6. Circuit arithmétique de convolution comprenant :

des premiers moyens de mémoire (42a) pour stocker une première séquence de données ;

des seconds moyens de mémoire (46) pour stocker une seconde séquence de données déterminées par un signal d'entrée ;

des premiers moyens de comptage (44), produisant une série cyclique de premières adresses ;

des seconds moyens de comptage (47) produisant une série cyclique de secondes adresses pour lesdits seconds moyens de mémoire ;

des moyens multiplicateurs-accumulateurs (41) ;

caractérisé en ce que lesdits seconds moyens de comptage (47) présentent ou bien une première séquence de comptage si un signal de sélection U/D présente un premier état ou une seconde séquence de comptage si ledit signal de sélection présente un second état et en ce que le circuit arithmétique de convolution comporte aussi :

des troisièmes moyens de mémoire (42b) pour stocker une troisième séquence de données ; les troisièmes moyens de mémoire étant aussi alimentés par les adresses des premiers moyens de comptage ; chacune desdites première et troisième séquences de données étant des facteurs de données de coefficients ;

des moyens de sélection (43) pour alimenter sélectivement sous le contrôle dudit signal de sélection une sortie représentant ladite première ou ladite troisième séquences de données lues sur lesdits premiers ou troisième moyens de mémoire en réponse auxdites premières adresses ;

des moyens (49) pour changer les cycles de comptage des seconds moyens de comptage, lesdits moyens (49) pour changer les cycles de comptage produisant un signal de commande (Sc) pour augmenter le comptage desdits seconds moyens de comptage d'un facteur de 2 au lieu de 1 quand ledit signal de sélection est dans un premier état et que les premiers moyens de comptage présentent une valeur prédéterminée ;

en ce que lesdits moyens multiplicateurs accumulateurs (41) calculent une série de produits en multipliant les éléments de ladite seconde séquence de données, lues sur ladite seconde mémoire, par ladite séquence de données fournies par lesdits moyens de sélection, et qui déterminent la somme desdits produits ; et

en ce que chaque élément de la séquence de données fournie par les moyens de sélection depuis les premiers ou troisièmes moyens de mémoire est lu en un endroit unique dans lesdits moyens de mémoire ; et en ce que la fréquence d'échantillonnage efficace des données calculées par les moyens multiplicateurs accumulateurs est un multiple ou un sous-multiple de la fréquence d'échantillonnage de la seconde séquence de données.

# FIG. 1.

PRIOR ART

EP 0 156 648 B1

FIG. 2.  PRIOR ART

FIG. 3.  PRIOR ART

EP 0 156 648 B1

FIG.4

FIG. 5.

g(k)
FACTORS

n

0          23

FIG. 7b.

ROM ADDRESS

15

8
7

0      7      15 16    24    31
SYSTEM COUNT

FIG. 6b.

ROM ADDRESS

15

7

0      7      15 16    24      31
SYSTEM COUNT

FIG. 8.

| ROM 42 ADDRESS | g(k) FACTORS |
|:---:|:---:|
| 0 | 3,20 |
| 2 | 11,12 |
| 3 | 7,16 |
| 4 | 4,19 |
| 5 | 8,15 |
| 7 | 0,23 |
| 8 | 2,21 |
| 10 | 10,13 |
| 11 | 6,17 |
| 12 | 5,18 |
| 13 | 9,14 |
| 15 | 1,22 |

FIG. 6a.

EP 0 156 648 B1

SYSTEM CTR | 0 | 3 | 2 | 5 | 4 | 7 | 8 | 11 | 10 | 13 | 12 | 15 | 16 | 19 | 18 | 21 | 20 | 23 | 24 | 27 | 26 | 29 | 28 | 31 | 0 | 3 | 2 | 5 | 4 | 7 | 8 | 11 | 10 | 13 | 12 | 15 |

ROM ADDRESS | 0 | 3 | 2 | 5 | 4 | 7 | 8 | 11 | 10 | 13 | 12 | 15 | 15 | 12 | 13 | 10 | 11 | 8 | 7 | 4 | 5 | 2 | 3 | 0 | 0 | 3 | 2 | 5 | 4 | 7 | 8 | 11 | 10 | 13 | 12 | 15 |

$AD_0$
$AD_1$
$AD_2$
$AD_3$

RAM ADDRESS | 0 | 1 | 2 | 3 | 4 | 5 | 0 | 1 | 2 | 3 | 4 | 5 | 0 | 1 | 2 | 3 | 4 | 5 | 0 | 1 | 2 | 3 | 4 | 5 | 1 | 2 | 3 | 4 | 5 | 0 | 1 | 2 | 3 | 4 | 5 | 0 |

INPUT DATA        x(5)        x(6)

R/W SIGNAL        ↓x(5)        ↓x(6)

RAM OUT x(t) | 0̄ | 1̄ | 2̄ | 3̄ | 4̄ | | 0̄ | 1̄ | 2̄ | 3̄ | 4̄ | 5̄ | 0̄ | 1̄ | 2̄ | 3̄ | 4̄ | 5̄ | 0̄ | 1̄ | 2̄ | 3̄ | 4̄ | 5̄ | 1̄ | 2̄ | 3̄ | 4̄ | 5̄ | | 1 | 2 | 3 | 4 | 5 | 0̄ |

ROM OUT g(k) | 20 | 16 | 12 | 8 | 4 | 0 | 21 | 17 | 13 | 9 | 5 | 1 | 22 | 18 | 14 | 10 | 6 | 2 | 23 | 19 | 15 | 11 | 7 | 3 | 20 | 16 | 12 | 8 | 4 | 0 | 21 | 17 | 13 | 9 | 5 | 1 |

MULT/ACC OUT y(k)   ⊠ y(20)   ⊠ y(21)   ⊠ y(22)   ⊠ y(23)   ⊠ y(24)   ⊠ y(25)

FIG. 7a.

EP 0 156 648 B1

FIG.9

| ROM 42a ADDRESS | g(k) FACTORS |
|---|---|
| 0 | 20 |
| 2 | 12 |
| 3 | 16 |
| 4 | 4 |
| 5 | 8 |
| 7 | 0 |
| 8 | 21 |
| 10 | 13 |
| 11 | 17 |
| 12 | 5 |
| 13 | 9 |
| 15 | 1 |
| 16 | 22 |
| 18 | 14 |
| 19 | 18 |
| 20 | 6 |
| 21 | 10 |
| 23 | 2 |
| 24 | 23 |
| 26 | 15 |
| 27 | 19 |
| 28 | 7 |
| 29 | 11 |
| 31 | 3 |

FIG. 10.

| ROM 42b ADDRESS | g(k) FACTORS |
|---|---|
| 0 | 23 |
| 2 | 15 |
| 3 | 19 |
| 4 | 7 |
| 5 | 11 |
| 7 | 3 |
| 8 | 22 |
| 10 | 14 |
| 11 | 18 |
| 12 | 6 |
| 13 | 10 |
| 15 | 2 |
| 16 | 21 |
| 18 | 13 |
| 19 | 17 |
| 20 | 5 |
| 21 | 9 |
| 23 | 1 |
| 24 | 20 |
| 26 | 12 |
| 27 | 16 |
| 28 | 4 |
| 29 | 8 |
| 31 | 0 |

FIG. 11.

# FIG.12.

EP 0 156 648 B1

FIG. 13.

EP 0 156 648 B1

SYSTEM CTR  0 3 2 5 4 7 8 11 10 13 12 15 16 19 18 21 20 23 24 27 26 29 28 31 0 3 2 5 4 7 8 11 10 13 12 15

ROM ADDRESS  0 3 2 5 4 7 8 11 10 13 12 15 16 19 18 21 20 23 24 27 26 29 28 31 0 3 2 5 4 7 8 11 10 13 12 15

RAM ADDRESS  0 1 2 3 4 5 6 7 8 9 10 11 12 13 14 15 16 17 18 19 20 21 22 0 1 2 3 4 5 6 7 8 9 10 11 12

INPUT DATA   x(20)   x(21)   x(22)   x(23)   x(24)   x(25)

R/W SIGNAL           ↓ x(20)   ↓ x(21)   ↓ x(22)   ↓ x(23)   ↓ x(24)   ↓ x(25)

RAM OUT x(t)  $\overline{0}$ $\overline{4}$ $\overline{8}$ $\overline{12}$ $\overline{16}$  $\overline{1}$ $\overline{5}$ $\overline{9}$ $\overline{13}$ $\overline{17}$  $\overline{2}$ $\overline{6}$ $\overline{10}$ $\overline{14}$ $\overline{18}$  $\overline{3}$ $\overline{7}$ $\overline{11}$ $\overline{15}$ $\overline{19}$  $\overline{4}$ $\overline{8}$ $\overline{12}$ $\overline{16}$ $\overline{20}$  $\overline{5}$ $\overline{9}$ $\overline{13}$ $\overline{17}$ $\overline{23}$

ROM OUT g(k)  $\overline{23}$ $\overline{19}$ $\overline{15}$ $\overline{11}$ $\overline{7}$ $\overline{3}$ $\overline{22}$ $\overline{18}$ $\overline{14}$ $\overline{10}$ $\overline{6}$ $\overline{2}$ $\overline{21}$ $\overline{17}$ $\overline{13}$ $\overline{9}$ $\overline{5}$ $\overline{1}$ $\overline{20}$ $\overline{16}$ $\overline{12}$ $\overline{8}$ $\overline{4}$ $\overline{0}$ $\overline{23}$ $\overline{19}$ $\overline{15}$ $\overline{11}$ $\overline{7}$ $\overline{3}$ $\overline{22}$ $\overline{18}$ $\overline{14}$ $\overline{10}$ $\overline{6}$ $\overline{2}$

MULT/ACC OUT y(k)                                        ⊠ y(23)